(19) Europäisches Patentamt
European Patent Office
Office européen des brevets

(11) EP 1 221 700 A1

(12) EUROPÄISCHE PATENTANMELDUNG

(43) Veröffentlichungstag:
10.07.2002 Patentblatt 2002/28

(51) Int Cl.⁷: G11C 19/00, G01R 31/3185

(21) Anmeldenummer: 01126135.1

(22) Anmeldetag: 02.11.2001

(84) Benannte Vertragsstaaten:
AT BE CH CY DE DK ES FI FR GB GR IE IT LI LU
MC NL PT SE TR
Benannte Erstreckungsstaaten:
AL LT LV MK RO SI

(71) Anmelder: SIEMENS AKTIENGESELLSCHAFT
80333 München (DE)

(72) Erfinder:
• Ghameshlu, Majid
  1110 Wien (AT)
• Krause, Karlheinz
  82152 Planegg (DE)
• Taucher, Herbert
  2340 Moedling (AT)

(54) Elektronischer Baustein mit verbesserter Boundary-Scan-Implementierung

(57) Um bei einem elektronischen Baustein (1) mit einer integrierten Schaltung (2), die einen Core (5) mit Dateneingängen und Datenausgängen (12), wobei der Baustein weiter Zellen (19) aufweist, die einen Eingang und/oder einen Ausgang (19) des Cores (5) vor- oder nachgeschaltet sind, und die in einem Scanmodus des Bausteins (1) zu einem Schieberegister zusammengeschaltet sind, eine Unabhängigkeit von der Qualität der Taktbaumbalancierung zu erreichen, wird zwischen den das Schieberegister bildenden Zellen (19) ein Delayelement angeordnet.

Fig. 1

**Beschreibung**

Die Erfindung bezieht sich auf einen elektronischen Baustein mit einer integrierten Schaltung, einem Core mit Dateneingängen und Datenausgängen, wobei der Core Zellen aufweist, die einem Eingang und/oder Ausgang des Cores vor- oder nachgeschaltet sind, und die in einem Scanmodus des Bausteins zu einem Schieberegister zusammengeschaltet sind.

Elektrische Bausteine dieser Art werden häufig als Application Specific Integrated Circuits (ASICs) ausgebildet, die nach ihrer Herstellung umfangreichen Qualifizierungsverfahren unterzogen werden. Mit ASICs bezeichnet man eine Anordnung von logischen Gatter- sowie Speicherschaltungen auf einem einzelnen Silizium Wafer. ASICs sind eine Ansammlung von Schaltungen mit einfachen Funktionen, wie Flipflops, Invertierern, NANDs und NORs sowie von komplexeren Strukturen, wie Speicheranordnungen, Addierern, Zählern und Phasenregelschleifen. Die verschiedenen Schaltungen werden in einem ASIC kombiniert, um eine bestimmte Anwendung durchzuführen. Hierbei werden ASICS in einer Vielzahl von Produkten, wie z.B. Konsumprodukten, wie Videospielen, digitaler Kameras, in Fahrzeugen und PCs, sowie in Highend Technologie Produkten, wie Workstations und Supercomputern eingesetzt.

Bekannte ASIC-Architekturen umfassen einen ASIC-Core, in dem die verschiedenen Schaltungselemente, die die Funktion des ASICs bilden, aufgenommen sind. Der ASIC-Core erhält die zu verarbeitenden Eingaben über Eingangspins und gibt diese nach deren Verarbeitung durch den ASIC-Core als Ausgabedaten über Ausgangspins wieder aus.

Um die Funktionalität von ASICs nach deren Herstellung zu überprüfen, sind verschiedene "Design For Test" (DFT)-Verfahren bekannt. Der Vorteil von DFT-Verfahren liegt darin, daß bereits bei der Konstruktion des Chips Schaltungselemente eingefügt werden, was ein späteres scan-basiertes Testen ermöglicht, die Anzahl der benötigten Testpunkte auf dem Board des ASICs reduziert und zugleich das Problem von nichtvorhandenen Zugriffspunkten auf dem Chip umgeht.

Bei bekannten ASICs wird im Rahmen der DFT-Verfahren zum Test der Baugruppe als auch zum Test des Input/Output-(I/O)-Bereiches des Bausteins ein IEEE-Standard Test Access Port und eine Boundary-Scan-Architektur gemäß des IEEE-Standards 1149.1 implementiert. Der Boundary-Scan (BS) wird z.B. im Detail in dem Buch "Boundary-Scan-Test: A Practical Approach", H. Bleeker, Klower Academic Publishers 1993, ISBN 0-7923-9296-5 beschrieben.

Die Anzahl der Pins bei Integrated Circuits (IC) und insbesondere bei ASICs steigt zunehmend an. Dabei werden Größenordnungen von 1000 Signalpins überschritten. Die Boundary-Scan-Kette des Boundary-Scans, wird durch die hohe Signalpinanzahl entsprechend lang und stellt ein Schieberegister mit dann über 1000 Flipflops dar. Diese Flipflops (FFs) sind örtlich entweder über die gesamte Chipfläche des ASICs oder den gesamten Rand des Chips verteilt. Der Schiebetakt des Schieberegisters im Scanmodus ist ein vom Systemtakt unabhängiger Takt. Da es sich um ein Schieberegister handelt, sind die HOLD- und SETUP-Zeiten zu beachten.

Damit die Ausgabe eines Flipflops vorhersehbar, d.h. nicht metastabil ist, müssen die Eingaben am Flipflop innerhalb der SETUP- und HOLD-Zeitanforderungen des Flipflops liegen. Bei der SETUP-Zeit handelt es sich um die Zeitperiode vor der Anstiegsflanke der Synchronisierungstaktung. Mit der HOLD-Zeit wird die Zeitperiode nach der Anstiegsflanke der Synchronisierungstaktung bezeichnet. Wenn die SETUP- und HOLD-Zeitkriterien des Flipflops nicht erfüllt werden ist die Ausgabe des Flipflops nicht sicher gewährleistet. Daher ist eine genaue Kenntnis der SETUP- und HOLD-Zeiten und derer Einhaltung von großer Bedeutung.

Die maximale Taktfrequenz für den Boundary-Scan-Test ist bei ASICs ungefähr ein Zehntel der Taktung des ASICs im Normalbetrieb. Deshalb spielen die SETUP-Zeitbetrachtung bei den heutigen schnellen Technologien (Deep Submicron) für das Schieberegister im Boundary-Scan bzw. im Scanmodus keine wichtige Rolle, insbesondere weil zwischen den benachbarten Boundary-Scan-Zellen lediglich ein Multiplexer vorhanden ist. Um so wichtiger sind jedoch die HOLD-Zeitbetrachtungen hinsichtlich benachbarter Zellen. Hier ist eine exakte Balancierung des Boundary-Scan-Taktbaums (CLOCKBS-Taktbaum) der über eine große Fläche verteilt ist, von immenser Bedeutung, damit ein möglichst kleiner CLOCKBS-Skew erreicht werden kann. Skew-Überschreitungen im CLOCKBS-Taktbaum verursachen HOLD-Zeitverletzungen, die den gesamten Test Access Port für den Baugruppentest unbrauchbar machen. Dieser Umstand wird noch dadurch verschärft, daß die benachbarten Boundary-Scan-Zellen nicht unbedingt zu geometrisch benachbarten Pins gehören müssen und im Layout weit auseinander liegen können.

Bei bekannten ASICs wird daher eine aufwendige exakte Balancierung des CLOCKBS-Taktbaums, der über eine große Fläche verteilt ist, vorgenommen, um so HOLD-Zeitverletzungen zu vermeiden. Eine Evaluierung ist jedoch erst nach der Erstellung des Layouts möglich und findet somit in der kritischen Designphase statt. Fehler, die zu diesem Zeitpunkt festgestellte werden, führen zu aufwendigen und kostenintensiven Designänderungen.

Der Erfindung liegt daher das Problem zugrunde, einen elektronischen Baustein zu schaffen, bei dem eine Balancierung des CLOCKBS-Taktbaums zumindest teilweise nicht mehr erforderlich ist, und zudem eine weitgehende Unabhängigkeit von der Taktbaumbalancierung erreicht wird.

Diese Aufgabe wird durch einen elektrischen Baustein gelöst, bei dem zwischen den das Schieberegister bildenden Zellen im Schiebepfad mindestens ein Verzögerungselement angeordnet ist.

Dieses Erfindungsgemäße Merkmal hat den Vorteil, daß eine aufwendige Generierung eines exakt balancierten Taktbaumes speziell für das Schieberegister in der kritischen Designphase entfällt.

Gemäß einer weiteren vorteilhaften Ausführungsform sind die Zellen Boundary-Scan-Zellen gemäß des Standards IEEE 1149, was eine besonders kostengünstige Implementierung der vorliegenden Erfindung darstellt.

Gemäß einer wichtigen vorteilhaften Ausführungsform sind die Delayelemente ein Teil der Zellen, wodurch um ein Delayelement erweiterte Boundary-Scan-Zellen gemäß des Standards IEEE 1149 gebildet werden, was Designaufwendungen bezüglich der Implementierung der vorliegenden Erfindung minimiert.

Gemäß einem weiteren vorteilhaften Ausführungsbeispiel ist zwischen allen Zellen mindestens ein Delayelement angeordnet ist, um den ClOCKBS-Taktbaum nicht mehr balancieren zu müssen.

Gemäß einem vorteilhaften Aspekt der vorliegenden Erfindung weist die Zelle einen Eingangsmultiplexer auf, der die Datenaufnahme entweder aus dem Core oder aus dem Schieberegister steuert, wobei das mindestens eine Delayelement unmittelbar vor dem Eingang des Eingabemultiplexers der Zelle angeordnet ist. Hierdurch können bei der Dimensionierung des Delayelements mögliche Signalbeeinflussungen, wie z. B. die Laufzeiten der Signale auf dem Schiebepfad, mit einbezogen werden.

Gemäß einem anderen vorteilhaften Aspekt der vorliegenden Erfindung ist das Delayelement in Abhängigkeit einer Set-Up-Time-Reserve und einer Taktzeit des Schieberegisters im Scanmodus dimensioniert. Dadurch kann die Dimensionierung der Delayelemente den Verschieden Hardware- und Taktbedingungen von ASICs angepaßt werden.

Gemäß einem vorteilhaften Ausführungsbeispiel der vorliegenden Erfindung wird die Dimensionierung des Delayelements gemäß der folgenden Ungleichung ausgewählt:

$$\text{Verzögerungszeit} \geq \text{CLOCKBS-Skew} - FF_{(n)pdtmin} + FF_{(n+1)HOLD},$$

wobei CLOCKBS-Skew das Skew des nicht balancierten Taktbaumes, $FF_{(n)pdtmin}$ die Propagation-Delay-Zeit des datentreibenden Flipflop und $FF_{(n+1)HOLD}$ die Holdzeit des nachfolgenden Flipflop ist. Dadurch kann sichergestellt werden das die individuelle Dimensionierung der Delayelemente auch Parameter der einzelnen Flipflops mit einschließt und eine Verletzung von Holdund Setup-Zeitkriterien dieser nicht stattfindet.

Ein Ausführungsbeispiel der Erfindung ist in den Zeichnungen dargestellt, und wird im Folgenden näher beschrieben. Es zeigen:

Fig. 1 eine schematische Darstellung einer Schnittstelle zweier ASICs gemäß der vorliegenden Erfindung;
Fig. 2 eine schematische Darstellung zweier aufeinanderfolgender Zellen des Schieberegisters eines erfindungsgemäßen ASICs der Fig. 1;
Fig. 3 eine schematische Darstellung des zeitlichen Ablaufs der Takt- und Datensignale in den Zellen der Fig. 2.

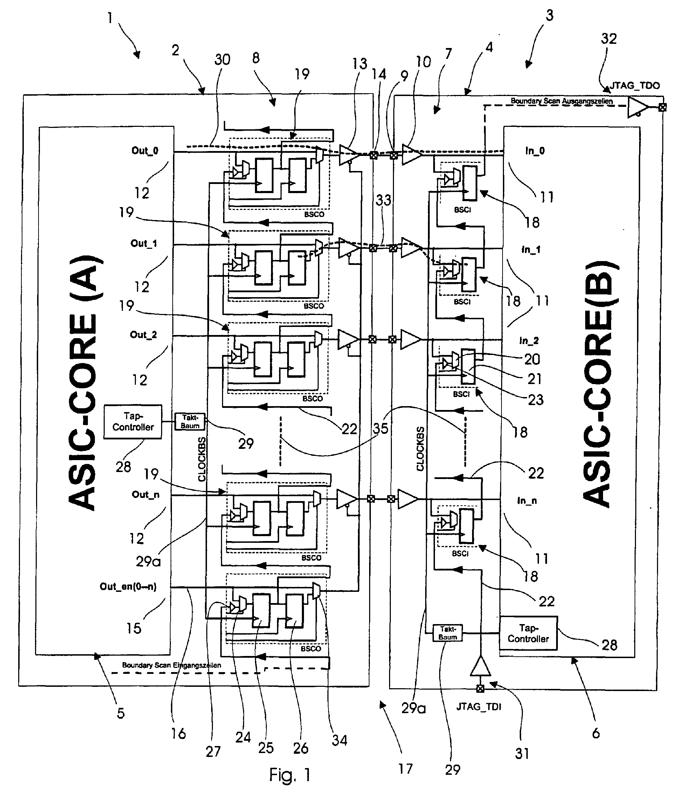

Fig. 1 zeigt einen ersten elektronischen Baustein 1 mit einer integrierten Schaltung 2, sowie einen zweiten elektronischen Baustein 3 mit einer integrierten Schaltung 4. Bei den elektronischen Bausteinen handelt es sich im vorliegenden Fall um Application Specific Integrated Circuits (ASICs), die im allgemeinen einen ASIC-Core, einen Eingabebereich und einen Ausgabebereich umfassen. In der Fig. 1 ist lediglich der Ausgabebereich 8 und ASIC-Core 5 des ersten ASICs 1, sowie der Eingabebereich 7 und ASIC-Core 6 des zweiten ASICS 3 dargestellt.

Die ASIC-Cores 5, 6 enthalten Schaltungselemente, wie Flipflops, Invertierer, NANDs und NORs, etc. , wobei die Anordnung der Schaltelemente in den Cores 5, 6 die spezifische Funktion der ASICs gewährleistet. Im Eingangsbereich 7 werden Daten parallel über Eingangspins 9, die jeweils mit einem Eingangsbuffer 10 verbunden sind, in den Baustein 3 eingelesen und an Core-Eingänge 11 (ln_0 bis ln_n) weitergegeben. Bevorzugterweise sind in dem ASIC-Core 6 nicht-dargestellte den Core-Eingängen 11 zugeordnete Eingangs-FFs angeordnet, die die Eingangsdaten abtakten.

Im Ausgangsbereich 8 des elektrischen Bausteins 1 befinden sich Core-Ausgänge 12, über die im Core 5 verarbeitete Daten aus dem Core 5 parallel ausgegeben werden, und zwar über Input/Output-(I/O)-Buffer 13 und jeweilig mit ihnen verbundene Ausgangspins 14.

In der Fig. 1 wird lediglich der Ausgangsbereich 8 des elektrischen Bausteins 1, sowie der Eingangsbereich 7 des elektrischen Bausteins 3 dargestellt, während der Eingangsbereich des Bausteins 1 und der Ausgangsbereich des Bausteins 3 nicht dargestellt sind. Bei den I/O- Buffern 13 handelt es sich im bevorzugten Ausführungsbeispiel um unidirektionale Tristate-Output-Buffer, die im folgenden als Ausgangsbuffer bezeichnet werden. Die Ausgangsbuffer können die logischen Zustände 0, 1 sowie ein Hochimpedanzzustand Z einnehmen. Der Zustand der Ausgangsbuffer 13 wird über ein an einem Enable-Input angelegtem Steuersignal gesteuert. Das Steuersignal wird im Normalbetrieb des ASICs 1,3 von einem Core-Steuerausgang 15 über eine Steuerleitung 16 geliefert.

In der Fig. 1 sind die Bausteine 1, 3 so angeordnet, daß sie ein Interface 17 bilden, über das Daten vom ASIC 1 zum ASIC 3 ausgetauscht werden.

Zum Test der Baugruppen der ASICs 1, 3, als auch zum Test der Ausgangsbereiche 8, und Eingangsbereiche 7 der ASICs 1, 3 ist ein IEEE-Standard Test Access Port und eine Boundary-Scan-Architektur gemäß des IEEE-Standards 1149.1 implementiert.

Dem Standard gemäß weisen die ASICs 1, 3 Boundary-Scan-Zellen 18,19 auf, wobei genauer zwischen einem jeweiligen Eingangsbuffer 10 und den Core-Eingängen 11 Boundary-Scan-Eingangszellen (BSCI) 18 und zwischen den Core-Ausgängen 12 und den Ausgangsbuffern 13, sowie zwischen dem Core-Steuerausgang 15 und den Ausgangsbuffern 13 Boundary-Scan-Ausgangszellen (BSCO) 19 vorgesehen werden.

In der Fig. 1 wurden lediglich die Boundary-Scan-Ausgangszellen 19 des ASICs 1 sowie die Boundary-Scan-Eingangszellen 18 des ASICs 3 schematisch dargestellt, jedoch nicht die Boundary-Scan-Eingangszellen des ASICs 1 sowie die Boundary-Scan-Ausgangszellen des ASICs 3.

Jede Boundary-Scan-Eingangszelle 18 umfaßt mindestens einen BSCI-Eingangsmultiplexer 20 mit einem nachgeschalteten BSCI-Flipflop 21. Der BSCI-Eingangsmultiplexer 20 erhält als Eingabe je nach Schaltung des Multiplexers 20 entweder die Eingabedaten aus dem Eingangsbuffer 10 oder Daten, die in das im Scanmodus gebildete Schieberegister über eine Schieberegisterleitung 22 eingeschobenen werden. Vom BSCI-Eingangsmultiplexer 20 gelangen die Daten in den BSCI-Flipflop 21. Der Ausgang des BSCI-Flipflop 21 ist über die Steuerleitung 22 mit einer im Schieberegister nachfolgenden Boundary-Scan-Eingangszelle, genauer gesagt mit einem Eingang des BSCI-Eingangsmultiplexer 20 verbunden. Wenn es die letzte Boundary-Scan-Eingangszelle 18 im Schieberegister ist, ist der Ausgang des BSCI-Flipflops 21 mit der ersten Boundary-Scan-Ausgangszelle 19 (In Figur 1 sind die BSCOs des ASICs 3 nicht explizit dargestellt), genauer gesagt mit einem Eingang eines später beschriebenen BSCO-Eingangsmultiplexers 24 verbunden.

Die BSCI-Flipflop 21 werden über Taktleitungen 29a und Taktbaum 29 vom einem Tap-Controller 28 getaktet.

Im erfindungsgemäßen ASIC 3 befindet sich im Eingangsbereich der Schieberegisterleitung 22 in den BSCI-Eingangsmultiplexer 20 ein Delay- bzw. Verzögerungselement 23, das die Signale, die sich entlang der Schieberegisterleitung 22 ausbreiten um einen vorbestimmten Zeitbetrag verzögert.

Die Boundary-Scan-Ausgangszellen 19 weisen jeweils einen BSCO-Eingangsmultiplexer 24 auf, dem ein erster BSCO-Flipflop 25 nachgeschaltet ist. Der BSCO-Eingangsmultiplexer 24 multiplext Daten kommend aus dem Core-Ausgang 12 oder über Schieberegisterleitungen 22 von einer vorhergehenden Boundary-Scan-Zelle in den ersten BSCO-Flipflop 25. Der Ausgang des ersten BSCO-Flipflops 25 ist über Steuerleitung 22 mit dem BSCO-Eingangsmultiplexer 24 einer im Schieberegister nachfolgenden Boundary-Scan-Ausgangszellen 19 verbunden um im Scanmodus, Daten aus dem ersten BSCO-Flipflop 25 an die nächste Boundary-Scan-Ausgangszelle 19 weiterzugeben.

Des weiteren weist die Boundary-Scan-Ausgangszelle 19 einen zweiten BSCO-Flipflop 26 auf, dessen Eingang mit dem Ausgang des ersten BSCO-Flipflops 25 verbunden ist und dessen Ausgang mit einem BSCO-Ausgangsmultiplexer 34 verbunden ist. Der zweite BSCO-Flipflop 26, der auch als Update-Flipflop bezeichnet wird, dient zur Speicherung der Daten, die während des Boundary-Scanmodus am Ausgang des ASICs 1 erscheinen sollen. Der BSCO-Ausgangsmulti-plexer 34 leitet je nach Zustand entweder Daten aus dem Core-Ausgang 12 oder aus dem zweiten BSCO-Flipflop 26 zu den Ausgängen des ASICs 1 weiter.

Ähnlich zu den Boundary-Scan-Eingangszellen 18 weisen die Boundary-Scan-Ausgangszellen 19 ebenfalls ein Verzögerungselement 27 im Eingangsbereich der Schieberegisterleitung 22 zu dem BSCO-Eingangsmultiplexer 24 auf. Das Delayelement 27 dient dazu, Signale auf den Schieberegisterleitungen 22 um einen vorbestimmten Betrag zu verzögern.

Zur Steuerung und Taktgebung der Boundary-Scan-Zellen 18, 19 weist jeder ASIC 1, 3 den Tap-Controller 28 auf. Der Tap-Controller 28 steuert mittels eines Modussignals die BSCO-Ausgangsmultiplexer 34 sowie über ein Schiebesignal die BSCI-Eingangsmultiplexer 20 sowie die BSCO-Eingangsmultiplexer 24 eines ASICs 1,3. Weiterhin versorgt im Scanmodus des ASICs der Tap-Controller 28 über den Taktbaum 29 und die Taktleitungen 29a die BSCI-Flipflops 21 und die ersten und zweiten BSCO-Flipflops 25 und 26 mit einer Taktung. Der Takt im Scanmodus, d.h. der Schiebetakt ist ein vom ASIC Systemtakt grundsätzlich unabhängiger Takt. Im bevorzugten Ausführungsbeispiel der vorliegenden Erfindung ist der Scanmodus ein Boundary-Scan-Test und die maximale Taktfrequenz während des Boundary-Scan-Tests liegt bei 12,5 MHz.

Zur Funktionsweise der ASICs 1, 3 ist nun folgendes anzumerken:

(1) Im Normalmodus, wird der Datenfluß beispielhaft für einen Datenpfad durch den Pfad 30 vom Core-Ausgang out_0 des ASICs 1 zum Core-Eingang 11 (In_0) des ASICs 3 dargestellt. Die Daten aus dem Core-Ausgang 12 (Out_0) des Cores 5 gelangen zu dem Ausgangsbuffer 13, da der BSCO-Ausgangsmultiplexer 34 nicht für den Scanmodus aktiviert ist. Der Coresteuerausgang 15 (Out_en(0-n)) sendet im Normalbetrieb ein Steuersignal an alle Ausgangsbuffer 13. Wenn das Steuersignal des Coresteuerausgang 15 den Ausgangsbuffer 13 aktiviert, gelangen die aus dem Core-Ausgang 12 ausgegebenen Daten über den Ausgangspin 14 und das Interface 17 zum Eingangspin 9 des zweiten ASICs 3. Im ASIC 3 werden die Daten über den Core-Eingang 11 (In_0) in den Core 6 eingegeben.

(2) Im Scanmodus sind die Boundary-Scan-Zellen eines ASICs 1, 3 zu einem Schieberegister geschaltet. Hierzu liefert der Tap-Controller 28 ein Schiebesignal an die BSCO-Eingangsmultiplexer 24 und die BSCI-Eingangsmultiplexer 20. Daten in der Form von Testvektoren werden nun über den Schieberegistereingang (JTAG_TDI) 31 mit dem Schiebetakt in das Schieberegister des ASICs 1,3 eingeschoben und treten nach Durchlaufen des gesamten Schieberegisters, d.h. der Boundary-Scan-Eingangszellen 18 und der Boundary-Scan-Ausgangszellen 19 (für ASIC 3 nicht dargestellt) bei Schieberegisterausgang 32 (JTAG_TD0) aus. Die in die Boundary-Scan-Ausgangszellen 19 eingeschobenen Daten können dazu genutzt werden, z.B. das Interface 17, wie es in der Fig. 1 zwischen zwei ASICs 1, 3 dargestellt ist, zu überprüfen. Hierzu werden wie bereits zuvor erwähnt Daten bzw. ein Testvektor im Scanmodus in das Schieberegister des ASICs 1 eingeschoben und gelangen so in den zweiten BSCO-Flipflop 26. Wenn der BSCO-Ausgangsmultiplexer 34 durch ein entsprechendes Modussignal des Tap-Controllers 28 in den Testmodus geschaltet ist, gelangen die Daten des zweiten BSCO-Flipflops 26, wie exemplarisch durch Pfad 33 angedeutet, über das Interface 17 in die BSCI-Eingangszellen 18 des ASICs 3. Die vom ASIC 1 übernommenen Daten können nun, wenn die Boundary-Scan-Zellen des ASIC 3 ebenfalls zu einem Schieberegister geschaltet werden aus dem ASIC 3 ausgeschoben und analysiert werden, um ggf. Fehler im Ausgangsbereich 8 des ASICs 1 oder im Eingangsbereich 7 des ASICs 3 festzustellen.

Wie bereits einleitend erwähnt, können bei herkömmlichen ASICs schlecht ausbalancierte Taktbäume für das Schieberegister zu HOLD-Time-Verletzungen und dadurch zu einer Unbrauchbarkeit des Test Access Ports führen. Um von der Qualität der Taktbaumbalancierung unabhängig zu sein, besitzen die Boundary-Scan-Zellen der ASICs 1, 3 der vorliegenden Erfindung die Delayelemente 23, 27. Die Delayelemente 23, 27 werden einzeln in Abhängigkeit der geometrischen Gegebenheiten, sowie der Eigenschaften der im Schieberegister vorausgehenden und nachfolgenden ersten BSCO-Flipflops 25 oder BSCI-Flipflops 21 bestimmt. Die Delayelemente 23, 27 können aufgrund der sehr großen SETUP-Time-Reserven (Periodendauer von ca. 80 ns bei 12,5 MHz) relativ groß dimensioniert werden, damit es über den der Technologie zugrundeliegenden Streuungen des nicht balancierten Taktbaums liegt. Gemäß der vorliegenden Erfindung wird die Verzögerungszeit des Delayelements gemäß der folgenden Ungleichung ausgewählt:

$$\text{Verzögerungszeit} \geq \text{CLOCKBS-Skew} - FF_{(n)pdtmin} + FF_{(n+1)HOLD},$$

wobei, CLOCKBS-Skew der Skew des nicht balancierten Taktbaumes, $FF_{(n)pdtmin}$ die Propagation-Delay-Zeit des datentreibenden Flipflops (n) und $FF_{(n+1)HOLD}$ die HOLD-Zeit des nachfolgenden Flipflops (n+1) ist. Durch das Einfügen der Delayelemente 23, 27 an geeigneter Stelle kann so das aufwendige generieren eines balancierten Taktbaumes, speziell für die Boundary-Scan-Kette in der kritischen Designphase des ASICs entfallen.

Im bevorzugten Ausführungsbeispiel der vorliegenden Erfindung werden die Delayelemente 23, 27 am Eingang der Schieberegisterleitungen 22 in die Eingangsmultiplexer 20, 24 angeordnet. Die Delayelemente 23, 27 könnten jedoch auch an anderen Positionen zwischen zwei im Schieberegister benachbarten Flipflops angeordnet werden.

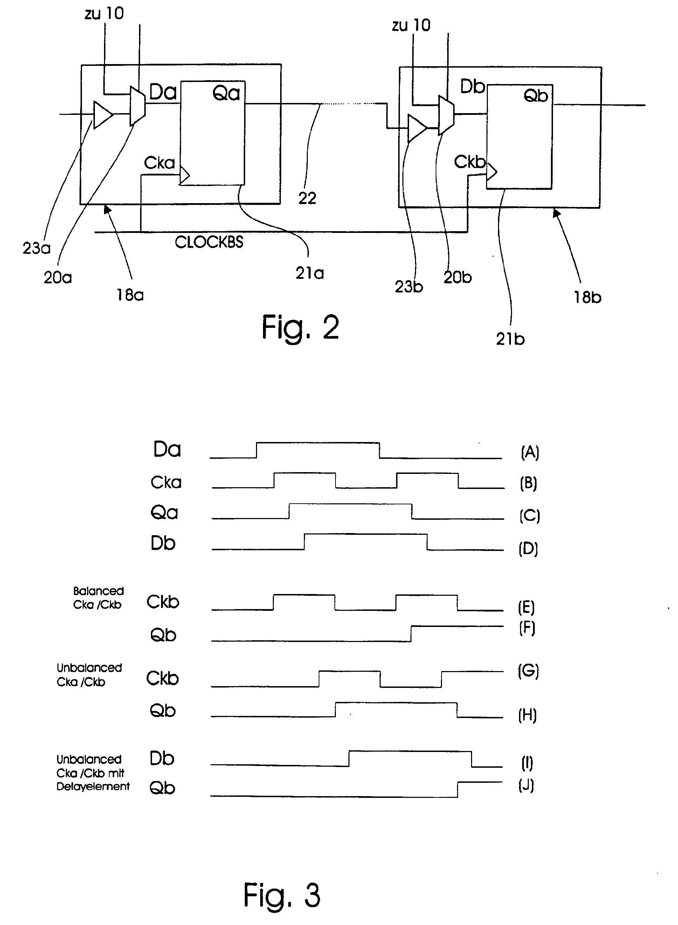

Bei einem anderen Ausführungsbeispiel der vorliegenden Erfindung werden nicht zwischen jeden benachbarten Flipflops im Schieberegister ein Delayelement eingefügt, sondern nur zwischen einigen im Schieberegister benachbarteten Flipflops. Unter Bezugnahme auf Fig. 2 und 3 wird das erfindungsgemäße Vorsehen eines Verzögerungselementes zwischen benachbarten Flipflops im Schieberegister im Detail erklärt.

Bezüglich der Figur 1 ist anzumerken, daß lediglich ein Ausschnitt eines Interfaces zwischen zwei ASICs dargestellt ist. Die gepunkteten Linien 32 sollen andeuten, das die aus Ausgangs-FFs 15, Ausgabe-Enable-FFs 18, BSCOs 19, Ausgangsbuffern 16, Scan-Enable-Zelle 25 und Verbindungen gebildete Gruppe eine beliebige Anzahl von Elementen nach dem in Figur 1 offenbarten Schema umfassen kann. Gleiches gilt für die Gruppe von BSCIs 11 in dem ASIC 3.

Fig. 2 stellt schematisch zwei Boundary-Scan-Eingangszellen 18a, 18b dar, die durch die Schieberegisterleitung 22 verbunden sind. Die BSCI-Flipflops 21a, 21b haben Eingänge Da, Db und Ausgänge Qa, Qb. Die Taktung der Flipflops 21a, 21b erfolgt über Takteingänge CKa bzw. CKb. Es wird zunächst angenommen, daß die Delayelement 23a, 23b nicht vor vorgesehen sind.

In Fig. 3 werden schematisch die Signalamplituden der verschiedenen Signale im zeitlichen Verlauf dargestellt, wobei lediglich zwei Signalzustände, ein "eins"- bzw. ein "null"-Zustand, dargestellt werden.

Zunächst liegt ein Dateneingangssignal (A) am Eingang Da des BSCI-Flipflops 21a an. Bei der nächsten Anstiegsflanke des am Takteingangs CKa anliegenden Taktsignals (B) wird der Wert des Datensignals (A) in den BSCI-Flipflop 21a übernommen und mit einem spezifischen clock-to-output-delay des BSCI-Flipflops 21a am Datenausgang Qa ausgegeben (C). Das Datensignal (C) kommt nun mit einer entsprechenden Laufzeitverzögerung am Eingang Db des BSCI-FFs 21b an (D).

Bei einem balancierten Schieberegister Taktbaum liegt das bei (E) dargestellte Taktsignal an CKb an. Der BSCI-Flipflop 21b nimmt daher mit der zweiten Anstiegsflanke des Signals (E) den zu diesem Zeitpunkt vorliegenden Wert des Signals (D) auf und gibt am Ausgang Qb das Datensignal (F) aus.

Im Falle eines unbalancierten CLOCKBS-Taktbaumes, wie er in (G) dargestellt ist, kommt es jedoch zu einer Timingverletzung. Durch die verspätete zweite Anstiegsflanke im Signal (G) "sieht" der BSCI-FF 21b die logische "eins" im Datensignal (D) nicht bei der zweiten Anstiegsflanke und gibt das falsche Datensignal (H), nämlich eine "null" am Ausgang Qb zum falschen Zeitpunkt aus.

Durch Einfügen der erfindungsgemäßen Delayelement 23, 27 vor den BSCI-Eingangsmultiplexern 23a, 23b wird der unbalancierte Taktbaum kompensiert. Das Datensignal, das bei Db ankommt (I) wird zeitlich nach hinten verschoben, so daß bei der zweiten Anstiegsflanke des Taktsignales (G) noch die logische "eins" am BSCI-Flipflop 21b anliegt, von diesem übernommen wird und mit einem clock-to-output-delay am Ausgang Qb als Datensignal (J) ausgegeben wird. In der obigen Diskussion und bei den in Figur 3 aufgezeigten Signalpfaden wurde angenommen, daß das hinzugefügte Delayelement 23a keine zusätzlichen Verzögerungen bewirkt.

Das zuvor erläuterte Beispiel beschreibt den erfindungsgemäßen Einsatz der Delayelemente bezüglich Boundary-Scan-Eingangszellen 18, findet jedoch entsprechend Anwendung bei den Boundary-Scan Ausgangszellen 19, und im allgemeinen bei allen getakteten Schieberegisterzellen. Obwohl die vorliegende Erfindung insbesondere bei ASICs, die eine Boundary-Scan-Funktionalität nach dem IEEE-Standard 1149.1 haben, Anwendung findet, ist anzumerken, daß die vorliegende Erfindung allgemein bei allen integrierten Schaltkreisen implementiert werden kann.

## Patentansprüche

1. Elektronischer Baustein (1,3) mit einer integrierten Schaltung (2,4), die folgendes aufweist:

   - einen Core (5,6) mit Dateneingängen (11) und Datenausgängen (12),
   - Zellen (18, 19), die einem Eingang (11) und/oder einen Ausgang (12) des Cores (5,6) vor- oder nachgeschaltet sind, und die in einem Scanmodus des Bausteins (1,3) zu einem Schieberegister zusammengeschaltet sind,

   **dadurch gekennzeichnet,**
   **daß** zwischen den das Schieberegister bildenden Zellen (18,19) im Schiebepfad (22) mindestens ein Delayelement (23) angeordnet ist.

2. Elektronischer Baustein (1,3) nach Anspruch 1,
   **dadurch gekennzeichnet,**
   **daß** die Zellen (18,19) Boundary-Scan-Zellen gemäß des Standards IEEE 1149 sind.

3. Elektronischer Baustein (1,3) nach einem der vorhergehenden Ansprüche,
   **dadurch gekennzeichnet,**
   **daß** zwischen allen Zellen (18,19) mindestens ein Delayelement (23) angeordnet ist.

4. Elektronischer Baustein (1,3) nach einem der vorhergehenden Ansprüche,
   **dadurch gekennzeichnet,**
   **daß** das Delayelement (23) ein Teil der Zellen (18, 19) sind.

5. Elektronischer Baustein (1,3) nach einem der vorhergehenden Ansprüche,
   **dadurch gekennzeichnet,**
   **daß** die Zelle (18,19) einen Eingangsmultiplexer (20,24) aufweist, der die Datenaufnahme entweder aus dem Core (5,6) oder aus dem Schieberegister steuert, wobei das mindestens eine Delayelement (23) unmittelbar vor dem Eingang des Eingabemultiplexers (20, 24) der Zelle (18,19) angeordnet ist.

6. Elektronischer Baustein (1,3) nach einem der vorhergehenden Ansprüche,
   **dadurch gekennzeichnet,**
   **daß** das Delayelement (23) in Abhängigkeit einer Set-Up-Time-Reserve und einer Taktzeit des Schieberegisters im Scanmodus dimensioniert ist.

7. Elektronischer Baustein (1,3) nach einem der vorhergehenden Ansprüche,
   **dadurch gekennzeichnet,**
   **daß** die Dimensionierung des Delayelements (23) gemäß der folgenden Ungleichung ausgewählt wird:

$$\text{Verzögerungszeit} \geq \text{CLOCKBS-Skew} - FF_{(n)pdtmin} + FF_{(n+1)HOLD},$$

wobei CLOCKBS-Skew das Skew des nicht balancierten Taktbaumes (29), $FF_{(n)pdtmin}$ die Propagation-Delay-Zeit des datentreibenden Flipflop (21a) und $FF_{(n+1)HOLD}$ die Holdzeit des nachfolgenden Flipflop (21b) ist.

Fig. 1

Fig. 2

Fig. 3

**Europäisches Patentamt**

# EUROPÄISCHER RECHERCHENBERICHT

Nummer der Anmeldung

EP 01 12 6135

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 6 134 517 A (LAW EDWIN S ET AL) 17. Oktober 2000 (2000-10-17) * Spalte 5, Zeile 12 - Zeile 37 * * Spalte 18, Zeile 62 - Spalte 19, Zeile 20 * * Abbildungen 1,4 * | 1-3,5-7 | G11C19/00 G01R31/3185 |
| Y | | 4 | |
| X | US 4 942 577 A (OZAKI HIDEHARU) 17. Juli 1990 (1990-07-17) | 1,3,5,6 | |
| Y | * Spalte 1, Zeile 47 - Spalte 3, Zeile 40 * * Abbildungen 1,2A * | 4 | |
| E | EP 1 179 740 A (AGERE SYSTEMS GUARDIAN CORP) 13. Februar 2002 (2002-02-13) * Spalte 5, Zeile 16 - Zeile 52 * * Abbildung 2 * | 1-3,5 | |
| A | PATENT ABSTRACTS OF JAPAN vol. 014, no. 240 (P-1051), 22. Mai 1990 (1990-05-22) & JP 02 061569 A (MATSUSHITA ELECTRIC IND CO LTD), 1. März 1990 (1990-03-01) * Zusammenfassung * * Abbildung 1 * | 1,3,6,7 | RECHERCHIERTE SACHGEBIETE (Int.Cl.7) G11C G01R |

-/--

Der vorliegende Recherchenbericht wurde für alle Patentansprüche erstellt

| Recherchenort | Abschlußdatum der Recherche | Prüfer |
|---|---|---|
| DEN HAAG | 20. März 2002 | Colling, P |

| | **EUROPÄISCHER RECHERCHENBERICHT** | | **Nummer der Anmeldung**<br>EP 01 12 6135 |
|---|---|---|---|

**Europäisches Patentamt**

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | PATEL S ET AL: "INTEGRATED SCAN TECHNIQUES EASE CHIP AND BOARD TESTS" EDN ELECTRICAL DESIGN NEWS, CAHNERS PUBLISHING CO. NEWTON, MASSACHUSETTS, US, Bd. 41, Nr. 24, 21. November 1996 (1996-11-21), Seiten 129-130,132,134,136,138,140,142, XP000681206 ISSN: 0012-7515 Seiten 129,130,132 und 134 * Abbildungen 1-5 *<br>----- | 1 | |
| | | | **RECHERCHIERTE SACHGEBIETE (Int.Cl.7)** |

Der vorliegende Recherchenbericht wurde für alle Patentansprüche erstellt

| Recherchenort | Abschlußdatum der Recherche | Prüfer |
|---|---|---|
| DEN HAAG | 20. März 2002 | Colling, P |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**                   EP 01 12 6135

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-03-2002

| Im Recherchenbericht angeführtes Patentdokument | | Datum der Veröffentlichung | Mitglied(er) der Patentfamilie | | Datum der Veröffentlichung |
|---|---|---|---|---|---|
| US 6134517 | A | 17-10-2000 | US | 5991908 A | 23-11-1999 |
| US 4942577 | A | 17-07-1990 | JP | 7046122 B | 17-05-1995 |
|  |  |  | JP | 63263480 A | 31-10-1988 |
| EP 1179740 | A | 13-02-2002 | EP | 1179740 A2 | 13-02-2002 |
| JP 02061569 | A | 01-03-1990 | KEINE | | |

EPO FORM P0461

Für nähere Einzelheiten zu diesem Anhang : siehe Amtsblatt des Europäischen Patentamts, Nr.12/82